# EUROPEAN PATENT SPECIFICATION

(11) **EP 2 472 599 B1**
(45) Date of publication and mention of the grant of the patent: **04.06.2014**
(21) Application number: 11176820.6
(22) Date of filing: 08.08.2011
(51) Int. Cl.: H01L 31/048, H01L 31/18

(54) **Photovoltaic modules in structural and safety glass for roofing of agricultural greenhouses.**
Photovoltaische Module in Struktur- und Sicherheitsglas für Dächer von landwirtschaftlichen Gewächshäusern
Modules photovoltaïques en verre structurel et sécurisé pour toiture de serres agricoles

(30) Priority: 30.12.2010 IT MI20102461
(43) Date of publication of application: 04.07.2012
(73) Proprietor: Costruire Insieme S.r.l., 22100 Como (CO) (IT)
(72) Inventor: Levrini, Sergio, 22100 Como (CO) (IT)
(74) Representative: Acco, Stefania

(56) References cited:
- US-A- 5 059 254
- US-A- 6 130 379
- US-A1- 2010 065 116

## Description

The present invention relates to a photovoltaic panel made from structural safety glass for covering greenhouses for agricultural crops.

In recent decades, both following the energy crisis due to the scarcity of oil for political reasons, and to fight air pollution, extensive researches were carried out in the field of renewable energies. Among these, solar energy is becoming increasingly important because of its wide availability and the absence of harmful emissions. In particular, the photovoltaic solar panels are going through a period of strong growth following the continuing progress of photovoltaic cells, increasingly efficient and inexpensive.

Said photovoltaic panels are obtained by coupling two glass plates and arranging photovoltaic cells therein. Panels are thus obtained that can be installed on the roofs of buildings and also for the construction of shelters and penthouses. Document US 2010/0065116 discloses a solar panel.

The coupling of the plates is made using sheets of thermoplastic polymers such as, for example, ethylene vinyl acetate (EVA), polyvinyl butyral (PVB), *Sentry Glass*® and *Sentry Glass Plus*® by Dupont ™ (SG®, SGP®).

If said photovoltaic panels are to be used for covering greenhouses, the photovoltaic cells may be suitably spaced from one another, in order to let the amount of light needed for cultivation pass. Tests have shown that with the cells that occupy 40% of the glass surface, the amount of light that passes is enough to ensure good quality of products grown, but it is necessary to allow the passage of ultraviolet rays in order to ensure a natural growth of the plants, as required by botanists.

According to present knowledge, neither EVA nor PVB could therefore be used, as said polymers must necessarily be admixed with UV stabilizers to prevent degradation, said stabilizers also serving as filters that prevent the passage of ultraviolet rays.

One way for solving the problem of blocking the passage of UV rays through the solar panels is through the use of special lamps that emit ultraviolet rays in a greenhouse covered with photovoltaic panels that do not allow the passage of the ultraviolet rays. However, this is not a particularly satisfactory solution.

An embodiment is cited, the tropical greenhouse of the Botanical Garden in Berlin. In this case it was necessary to resort to the use of *Sentry Glass Plus*® by Dupont^{™} as being stable to ultraviolet light, it does not require a UV stabilizer to protect it. The *Sentry Glass Plus*® by Dupont guarantees, among other things, a mechanical strength of the panel significantly higher than other polymers.

The Applicant has observed that due to the extreme fragility of photovoltaic cells, photovoltaic panels are very difficult to make using the *Sentry Glass Plus*® which, due to its too high elastic modulus, would cause the rupture of cells during the step of coupling the glasses.

Patent application MI2007A001576, to the name of the same applicant, describes the process of manufacturing a photovoltaic panel, to be used if a high mechanical strength of the panel combined with a limited weight are required. Said panel is made by coupling two sheets of glass with *Sentry Glass Plus*®*,* and a third sheet of glass with PVB or EVA, the photovoltaic cells being inserted between the third plate and the first two. In this way the first two sheets, coupled with *Sentry Glass Plus*®, impart the necessary mechanical strength to the panel, while the third one, coupled with PVB or EVA, allows incorporating the photovoltaic cells. However, there remains the serious drawback of preventing the passage of ultraviolet rays due to the use of PVB or EVA.

It is possible to make photovoltaic panels using the *Sentry Glass*® which does not require the use of anti UV additives, thus overcoming the problem of the opacity of ultraviolet rays. However, such product is too expensive both for the particularly high cost of the polymer, and for the cost of the production process.

The research is currently aimed at using photovoltaic paints, that is, coatings capable of producing electric energy. In that case, covering glasses by 40% of the surface, panels are obtained that have both the required darkening level and the transparency of the ultraviolet rays. Presently, however, the development of this technology is still in the preliminary step.

The present invention aims at overcoming at least partly the drawbacks described by a photovoltaic panel, according to claim 1, obtained by incorporating a plurality of photovoltaic cells between two sheets of glass coupled with thermoplastic polymers not added with stabilising substances against ultraviolet rays, the degradation of said polymers being contained within values that enable high yields of the cells, as well as a high transparency to ultraviolet rays, for a period of time sufficient to amortize the investment.

The research carried out by the applicant has surprisingly shown that the use of said thermoplastic polymers without the addition of stabilizers against ultraviolet rays allows obtaining photovoltaic panels suitable for covering greenhouses, wherein the degradation due to ultraviolet rays is contained within quite narrow limits that allow the use of said panels for many years, with a limited loss of efficiency (10÷15%). The invention relates to a photovoltaic panel for covering greenhouses for agricultural crops, of the type comprising a plurality of photovoltaic cells inserted between two sheets of glass coupled together by transparent polymeric material, said cells being arranged in such a way as to cover a percentage of the glass surface suitable for letting the amount of light needed for cultivation pass, characterised in that said polymeric material is a thermoplastic polymer free from stabilising substances against ultraviolet rays. The polymer that showed the best behaviour is PVB, as it is more resistant to high temperatures that develop due to the heating of the cells due to both solar radiation and to the passage of electrical current.

By polymer free from stabilizers against ultraviolet rays it is meant a polymer not added with said stabilizers. By stabilising substances against ultraviolet rays it is meant compositions that comprise inorganic or organic additives, well known to the man skilled in the art, which impart resistance to the polymer degradation caused by ultraviolet radiation.

Preferably, the photovoltaic cells are cells based on crystalline, multi-crystalline or poly-crystalline silicon.

Preferably, the photovoltaic cells only cover a portion of the surface of the glass sheets. In one embodiment, the photovoltaic cells cover about 40% of the glass sheet surface.

A method for manufacturing said photovoltaic panels is herein disclosed, said method comprising the following steps:
- preparing the glasses to be assembled;
- assembling the glasses through said sheets of transparent polymeric material not added with stabilising substances against ultraviolet rays, having inserted the photovoltaic cells between said two sheets of transparent polymeric material;
- carrying out the lamination process, on the assembled panel, so as to obtain the adhesion between the various elements making up the photovoltaic panel.

The lamination process for manufacturing photovoltaic panels consisting of two glasses provides for coupling two glass sheets by two low modulus polymer sheets (PVB or EVA), having inserted the photovoltaic cells between these last mentioned, and inserting the whole in a vacuum bag, in order to remove the air that remains trapped between the glass and the polymer sheets. After that, the whole is inserted in an autoclave wherein temperature is made rise until the polymer reaches the conditions whereby the adhesive bond between the same polymer, the photovoltaic cells and the glasses is obtained.

At this point, temperature and pressure inside the autoclave are made rise. The combined effect of pressure, applied on the surfaces of the layered sheet, combined with the depression applied to the vacuum bag, causes the total escape of the air trapped in the panel.

After the permanence of the temperature, pressure and depression values for the period required for obtaining the bond between glass and polymer, the temperature is gradually made drop, according to a suitable descent ramp, while pressure and depression are actually maintained up to the end of the curing cycle.

The use of photovoltaic panels according to the invention therefore allows obtaining energetically self-sufficient greenhouses, since the photovoltaic cells produce the electric energy required for the operation of the various systems present in the greenhouse, and there is no energy consumption for the production of ultraviolet rays with special lamps.

The invention shall now be described, by way of a non-limiting example, according to a preferred embodiment and with reference to the annexed figures, wherein:
- figure 1 shows the sequence of the various layers that make up the photovoltaic panel according to the invention;
- figures 2 (a, b) show the equipment for manufacturing the photovoltaic panel;
- figure 3 shows a graph showing the transmittance T (%) based on the wavelength (nm) of the incident light, measured on a photovoltaic panel according to an embodiment of the present invention;
- figure 4a shows a graph showing the absorption spectrum of type a and type b chlorophyll chromophore pigments and carotenoids, whereas figure 4b shows the photosynthesis reaction speed based on the wavelength of the radiated light;
- figure 5 shows a graph showing the characteristic I-V measured on a photovoltaic panel according to an embodiment of the present invention at the beginning of the exposure to the radiation of a solar light simulator (curve A), compared with characteristic I-V after 2000 hours of radiation (curve B).

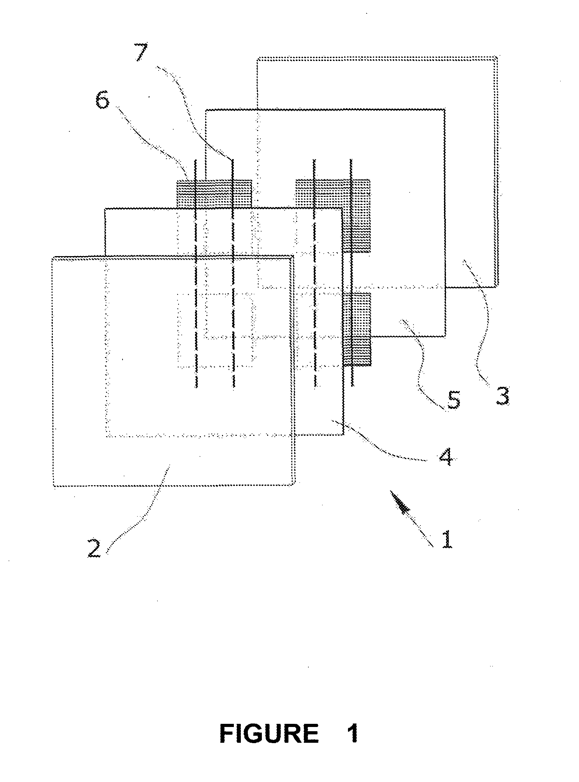

With reference to fig. 1, reference numeral 1 shows a photovoltaic panel according to an embodiment of the invention.

According to a preferred embodiment, said photovoltaic panel 1 comprises a first glass 2 and a second glass 3, connected to each other by a first sheet 4 and a second sheet 5 of a thermoplastic polymer with low elastic modulus, not added with anti ultraviolet ray substances, whereinbetween a plurality of photovoltaic cells 6 is inserted. Said low modulus thermoplastic polymer preferably comprises polyvinybutyrral (PVB) and ethylene vinyl acetate (EVA, EVA+). Due to the high temperatures that develop, especially in the presence of strong solar radiation, it is preferable to use PVB, thanks to its better resistance to high temperatures, compared to EVA. Hereinafter, reference shall be made to PVB, however the man skilled in the art shall have no difficulty to use the teachings contained in the present description for treating other thermoplastic polymers.

For example, each sheet of thermoplastic polymer is a plasticized sheet based on partially acetalyzed polyvinyl alcohols (PVB resin) which comprises 60% to 85% by weight of PVB resin, 14% to 39% by weight of low polarity plasticizer and up to 10% by weight of one or more non ionic surfactants as additive that increases the low polarity plasticizer solubility in the PVB resin. Such elasticised sheet is described in US 2004/0249068.

The photovoltaic cells 6 are connected to one another by electrical conductors 7, according to the prior art, which carry the electric current produced outside the photovoltaic panel 1.

The manufacture of the photovoltaic panel 1 according to an example of the invention provides for the following steps:
- preparing glasses 2, 3 to be assembled;
- assembling glasses 2 and 3 by said PVB sheets 4, 5, having inserted the photovoltaic cells 6 between said two PVB sheets 4, 5;
- carrying out the process according to the invention, or lamination, on the assembled panel 1, so as to obtain the adhesion between the various elements making up the photovoltaic panel 1.

The glass preparation comprises the following steps:
- cutting the two glasses 2, 3 to size;
- tempering or hardening said glasses 2, 3;
- optionally performing HST (Heat Soak Test) for tempered glasses, for detecting any presence of nickel sulphite;
- washing the glasses.

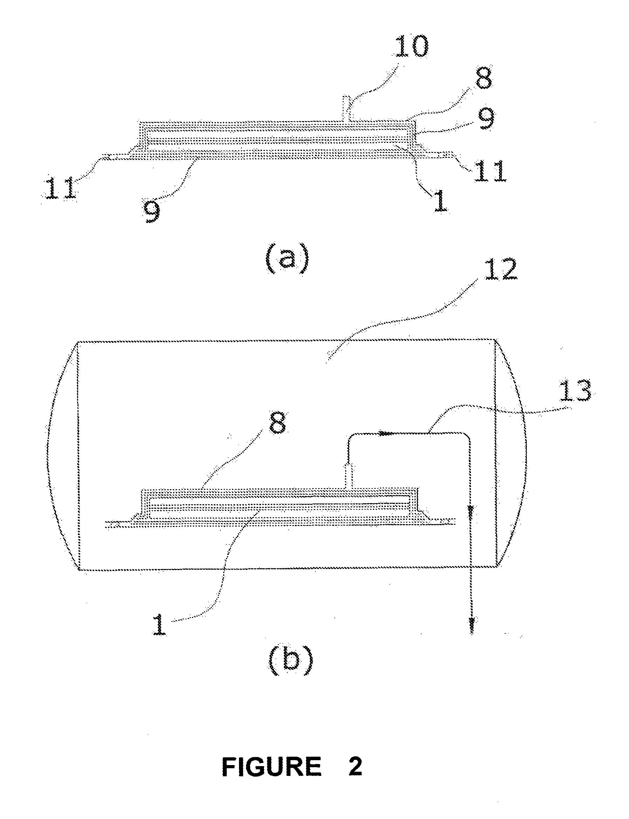

The glass preparation is followed by the assembly thereof, which includes the insertion of photovoltaic cells 6. Said assembly operation provides for the following steps:
- positioning the first glass 2, preferably with the sealed side in contact with the first PVB sheet 4;
- laying the first PVB sheet 4;
- laying the photovoltaic cells 6 with a surface coating based on the screening to be obtained, for example 40%;
- arranging the electric output conductors 7;
- laying the second PVB sheet 4;
- positioning the second glass 3;
- trimming the excess plastic material;
- inserting the assembled panel 1 in a vacuum bag 8 (fig. 2a) prepared, according to the prior art, by arranging suitable and spaced apart ventilation fabrics 9, as well as a retain valve 10 for depression, said vacuum bag 8 being closed with sealer 11;
- inserting the vacuum bag 8 containing the assembled panel 1 in an autoclave 12, having connected the retain valve 10 to the vacuum system of autoclave 12 through hoses 13 (fig. 2b);
- carrying out the thermal cycle and applying pressure and depression, according to timelines especially designed for the process;
- opening the vacuum bag 8 and trimming the plastic material escaped;
- checking the quality of the panel 1 obtained according to the process described. The vacuum bag 8 may be made with simple disposable plastic sheets or membranes, for example of silicone rubber, usable multiple times.

The curing cycle, starting from the room temperature of about 20°C, provides for a temperature rising step, a holding step and a dropping step of the same. The vacuum bag 8 is placed in depression, while pressure within autoclave 12 is made rise.

The temperature adjustment is made on the air present within autoclave 12, however what matters for the outcome of the operation is the temperature of glasses since it determines the temperature of PVB sheets. Once the thermal cycles of the glasses has been established, using known techniques, a calculation is made of what the thermal cycle of the air present within the autoclave should be, based on the thermal masses of the air and of glasses and on the thermal exchange conditions between air and glasses, said thermal exchange varying according to ventilation and air pressure, which varies during the curing cycle.

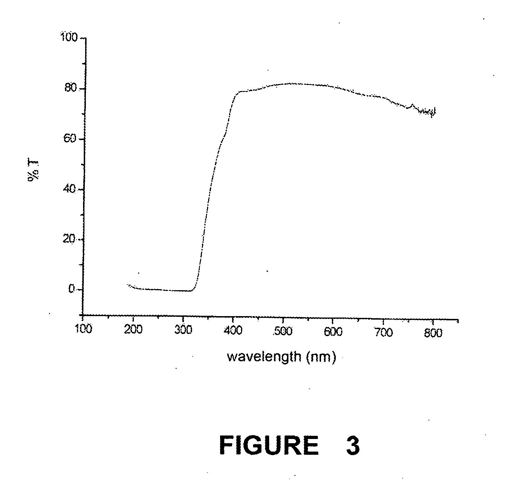

Figure 3 is a graph showing transmittance T (%) in the visible wavelength interval (350-800 nm) based on the wavelength (nm) measured on a photovoltaic panel formed by an arrangement of photovoltaic cells of multi-crystalline silicon interposed between two glass substrates, each glass substrate being covered, in the respective inner surface thereof facing the photovoltaic cells, with a PVB polymeric layer free from stabilising substances for UV rays. The arrangement of photovoltaic cells is therefore arranged between the two PVB layers. Each glass substrate is 3 mm thick and each PVB layer is 0.76 mm thick. The arrangement of photovoltaic cells of the present example comprises 4 cells connected in series to one another. The total area of the module is 0.16 m².

From the graph of figure 3 it is seen that at wavelengths comprised between about 400 nm and 800 nm, the transmittance is about 80%, while it is higher than 50% in the wavelength interval between 350 nm and 400 nm.

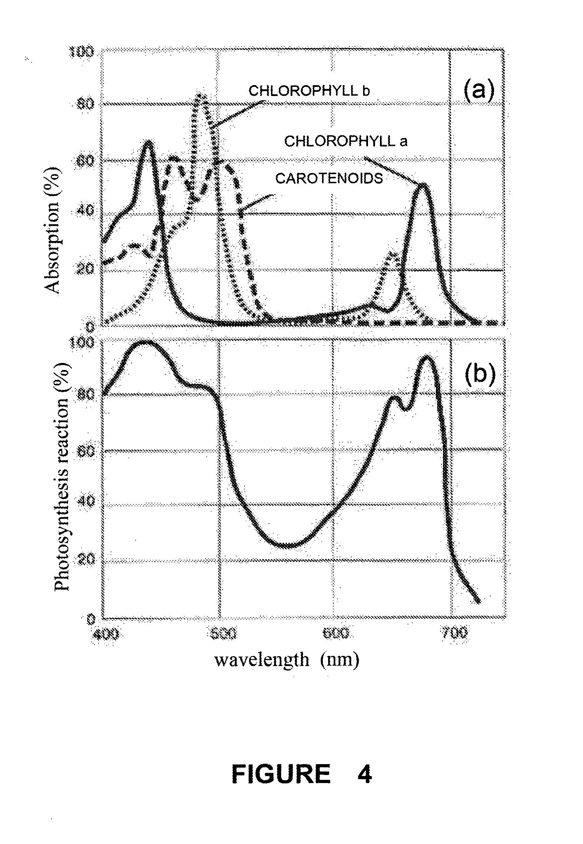

Figure 4a is a graph that shows the absorption spectrum of type a and type b chlorophyll chromophore pigments and of carotenoids, while figure 4b shows the photosynthesis reaction speed based on the wavelength of the radiated light. It is noted that there is a strong increase in the photosynthesis kinetics when there is a radiation with light radiation between 400 and 500 nm, an interval wherein the transmittance of the photovoltaic panel of the example of figure 3 is about 80%. By overlapping the two graphs of figure 4a and 4b, it is noted that the radiation through the photovoltaic panel allows having a photosynthesis speed equal to about 70%-80% of what would be under direct solar radiation.

Tests were performed on the photovoltaic panel of the example of figures 3 and 4a-4b for determining the degradation of the electric features of the arrangement of photovoltaic cells of the panel over time, indicative of a possible degradation of the polymeric material that encloses the cells. The photovoltaic panel was subject to a radiation at a power of about 1000 W/m² by a solar light simulator for a total of 2000 hours, so as to simulate the natural solar radiation in an average life time of the panel of about 20 years.

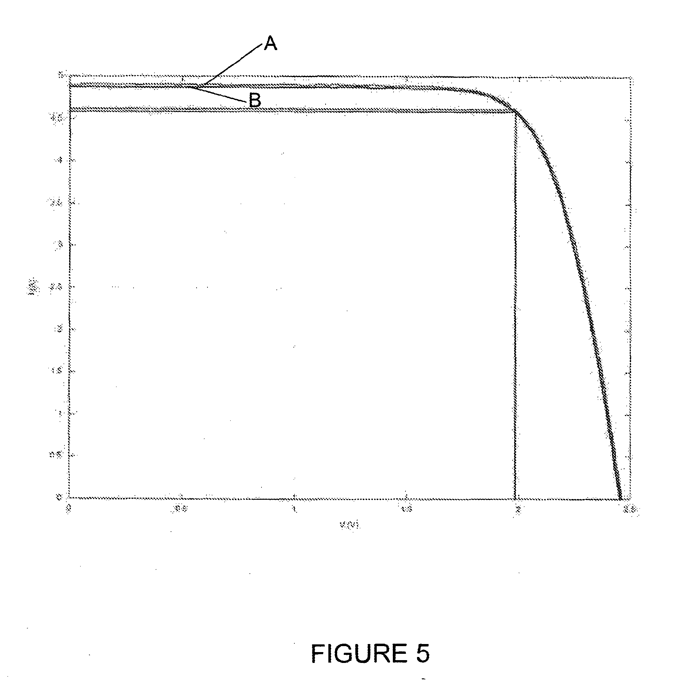

Figure 5 shows a graph showing the current-voltage characteristic (I-V) measured on the panel at the beginning of the test step in the solar light simulator (curve A), compared with characteristic I-V after 2000 hours of radiation (curve B). It is noted that the two curves substantially overlap, indicating a substantial absence of degradation of the panel over time. The open circuit voltage (V_{oc}) of the panel of the present example is about 2.46 V and the efficiency of the panel is about 5.7%, such values not varying considerably over the radiation time during the simulation test.

## Claims

1. Photovoltaic panel (1) of structural safety glass for covering greenhouses intended for agricultural crops, of the type comprising a plurality of photovoltaic cells (6) inserted between two glass sheets (2, 3) coupled to one another by two sheets of transparent polymeric material (4, 5), said photovoltaic cells (6) being positioned between said two sheets of transparent polymeric material (4, 5), **characterised in that** said transparent polymeric material is free from stabilising substances for ultraviolet rays.

2. Photovoltaic panel (1) according to claim 1, **characterised in that** said transparent polymeric material free from stabilising substances for ultraviolet rays is polyvinylbutyrral (PVB).

3. Photovoltaic panel (1) according to claim 1, **characterised in that** said transparent polymeric material free from stabilising substances for ultraviolet rays is ethylene vinyl acetate (EVA, EVA+).

4. Photovoltaic panel (1) according to claim 1, **characterised in that** said photovoltaic cells (6) only cover a portion of the surface of said glass sheets (2, 3).

5. Photovoltaic panel (1) according to claim 4, **characterised in that** said photovoltaic cells (6) cover about 40% of the surface of said glass sheets (2, 3).

6. Photovoltaic panel according to claim 1, wherein the polymeric material is a thermoplastic polymer and each sheet of transparent polymeric material (4, 5) is a plasticized sheet based on partially acetalyzed polyvinyl alcohols which comprises 60% to 85% by weight of partially acetalyzed polyvinyl alcohols, 14% to 39% by weight of low polarity plasticizer and up to 10% by weight of one or more non ionic surfactants as additive that increases the low polarity plasticizer solubility in the partially acetalyzed polyvinyl alcohols.

## Patentansprüche

1. Photovoltaikmodul (1) aus Struktur-Sicherheitsglas zum Abdecken von für Nutzpflanzen vorgesehenen Gewächshäusern, von der Art, die mehrere Photovoltaikzellen (6) umfasst, die zwischen zwei Glasplatten (2, 3) eingefügt sind, welche durch zwei Platten aus transparentem Polymermaterial (4, 5) miteinander verbunden sind, wobei die Photovoltaikzellen (6) zwischen den beiden Platten aus transparentem Polymermaterial (4, 5) angeordnet sind, **dadurch gekennzeichnet, dass** das transparente Polymermaterial keine UV-Strahlungsstabilisatoren enthält.

2. Photovoltaikmodul (1) nach Anspruch 1, **dadurch gekennzeichnet, dass** das transparente Polymermaterial, das keine UV-Strahlungsstabilisatoren enthält, Polyvinylbutyral (PVB) ist.

3. Photovoltaikmodul (1) nach Anspruch 1, **dadurch gekennzeichnet, dass** das transparente Polymermaterial, das keine UV-Strahlungsstabilisatoren enthält, Ethylenvinylacetat (EVA, EVA+) ist.

4. Photovoltaikmodul (1) nach Anspruch 1, **dadurch gekennzeichnet, dass** die Photovoltaikzellen (6) nur einen Teil der Oberfläche der Glasplatten (2, 3) bedecken.

5. Photovoltaikmodul (1) nach Anspruch 4, **dadurch gekennzeichnet, dass** die Photovoltaikzellen (6) etwa 40% der Oberfläche der Glasplatten (2, 3) bedecken.

6. Photovoltaikmodul nach Anspruch 1, wobei das Polymermaterial ein thermoplastisches Polymer ist und jede Platte aus transparentem Polymermaterial (4, 5) eine weichmacherhaltige Platte auf Basis von teilweise acetalisierten Polyvinylalkoholen ist, welche 60 bis 80 Gew.-% teilweise acetalisierte Polyvinylalkohole, 14 bis 39 Gew.-% Weichmacher mit geringer Polarität und bis zu 10 Gew.-% eines oder mehrerer nichtionischer Tenside als Zusatz enthält, welcher die Löslichkeit des Weichmachers mit geringer Polarität in den teilweise acetalisierten Polyvinylalkoholen erhöht.

## Revendications

1. Panneau photovoltaïque (1) en verre de sécurité structurel destiné à recouvrir des serres prévues pour produits agricoles, du type comprenant une pluralité de cellules photovoltaïques (6) qui sont insérées entre deux feuilles de verre (2, 3) qui sont reliées entre elles par deux feuilles en matière polymère transparente (4, 5), lesdites cellules photovoltaïques (6) étant positionnées entre lesdites deux feuilles en matière polymère transparente (4, 5), **caractérisé par le fait que** la matière polymère transparente est dépourvue d'agents stabilisateurs pour le rayonnement ultraviolet.

2. Panneau photovoltaïque (1) selon la revendication 1, **caractérisé par le fait que** la matière polymère transparente dépourvue d'agents stabilisateurs pour le rayonnement ultraviolet est du polybutyral de vinyle (PVB).

3. Panneau photovoltaïque (1) selon la revendication 1, **caractérisé par le fait que** la matière polymère transparente dépourvue d'agents stabilisateurs pour le rayonnement ultraviolet est de l'éthylène-acétate de vinyle (EVA, EVA+).

4. Panneau photovoltaïque (1) selon la revendication 1, **caractérisé par le fait que** les cellules photovoltaïques (6) ne couvrent qu'une partie de la surface des feuilles de verre (2, 3).

5. Panneau photovoltaïque (1) selon la revendication 4, **caractérisé par le fait que** les cellules photovoltaïques (6) couvrent 40 % à peu près de la surface des feuilles de verre (2, 3).

6. Panneau photovoltaïque selon la revendication 1, dans lequel la matière polymère est un polymère thermoplastique et chaque feuille en matière polymère transparente (4, 5) est une feuille plastifiée sur la base d'alcools polyvinyliques partiellement acétalisés qui comprend entre 60 et 80 % en poids d'alcools polyvinyliques partiellement acétalisés, entre 14 et 39 % en poids de plastifiant à faible polarité et jusqu'à 10 % en poids d'un ou de plusieurs agents tensioactifs non-ioniques comme additif qui augmente la solubilité du plastifiant à faible polarité dans les alcools polyvinyliques partiellement acétalisés.
